# EUROPEAN PATENT APPLICATION

(11) **EP 4 568 055 A1**
(43) Date of publication of application: **11.06.2025**
(21) Application number: 24186766.2
(22) Date of filing: 05.07.2024
(51) Int. Cl.: H02J 7/00, G01R 31/36, H01M 10/44, G01R 31/385, G01R 31/387, H01M 10/42

(54) **LOAD MEASUREMENT METHOD AND APPARATUS OF BATTERY BALANCER, COMPUTER DEVICE AND STORAGE MEDIUM**

(30) Priority: 05.12.2023 CN 202311652466
(71) Applicant: Shenzhen Smartsafe Tech Co., Ltd., Shenzhen, Guangdong (CN)
(72) Inventor: LIU, Jun, Shenzhen (CN); ZHAN, Wei, Shenzhen (CN)
(74) Representative: Petraz, Gilberto Luigi

(57) **Abstract**

An embodiment of present application discloses a load measurement method of a battery balancer, which includes: performing discharging control on a cell until reaching cutoff voltage; performing charging control on the cell according to preset constant charging power until reaching a preset upper limit of a cell load, generating cell charging efficiency information, and generating cell discharging efficiency information; performing charging/discharging cycle control on the cell, where the charging/discharging cycle control includes multiple charging control and corresponding multiple discharging control, and obtaining charging/discharging cycle control efficiency information; and calculating and generating cell load state information by using a cell load algorithm based on the cell charging efficiency information, the cell discharging efficiency information and the charging/discharging cycle control efficiency information, where the cell load algorithm is configured in a preset cell charging/discharging management strategy, and generating a cell load state curve according to the cell charging/discharging management strategy. By implementing the method in the embodiment of the present application, the calculation accuracy of a SOC can be improved, the battery management and performance evaluation can be optimized, and the evaluation capacity of the charging/discharging efficiency can be improved.

## Description

### Technical Field

The present application relates to the technical field of new energy storage, more particularly relates to a load measurement method and apparatus of a battery balancer, a computer device and a storage medium.

### Background Art

With increasing concern on the environmental protection and sustainable development around the world, new-energy vehicles, as an important substitute of traditional fuel vehicles, are widely popularized and used. As a core energy storage apparatus of the new-energy vehicle, the performance and safety of power batteries become one of important factors affecting the industry development. However, the power battery may be susceptible to various factors in a long-term use process, such as overcharge and over-discharge, high temperature and the like, resulting in attenuation of battery capacity, decrease of safety and even accidents. In order to ensure the safety of the battery and prolong the service life, to research and develop a battery management system (BMS) becomes one of necessary technical means. The BMS is mainly used to monitor and manage the batteries, and the accurate estimation of a state of charge (SOC) of the power battery is one of key functions of the BMS. The accurate estimation of SOC may facilitate the control of a charging and discharging process of the battery to avoid the overcharge and over-discharge of the battery, thereby improving the service life and safety of the battery. At present, methods for estimating the SOC mainly include traditional methods, deep learning algorithms and model-based estimation methods. A current integration method and an open-circuit voltage method in the traditional methods are common estimation methods and have certain limitation. The current integration method is simple and direct, but neglects the influence of the charging/discharging efficiency on the SOC; and the open-circuit voltage method consumes plenty of time and is affected by factors such as a battery health state, temperature and the like and has an uncertain curve. In order to improve the estimation accuracy and reliability of the SOC, the deep learning algorithm and the model-based estimation method are introduced. The deep learning algorithm explores a nonlinear relation between the SOC and external state information by training a large number of data, but needs a complex network structure and vast calculation resources. The model-based estimation method mainly adopts a Kalman filter algorithm, which predicts the SOC of the battery by establishing an equivalent circuit model of the battery, and highly depends on the accuracy of the battery model.

### Summary of the Invention

An embodiment of the present application provides a load measurement method and apparatus of a battery balancer, a computer device and a storage medium, which aims at solving the problem of high uncertainty in load measurement of cells.

In a first aspect, an embodiment of the present application provides a load measurement method of a battery balancer, which includes: starting a cell in a battery pack corresponding to a connection port through the connection port of the battery balancer, and performing discharging control on the cell until reaching cutoff voltage; performing charging control on the cell according to preset constant charging power until reaching a preset upper limit of a cell load, and generating cell charging efficiency information; performing discharging control on the cell until reaching the cutoff voltage according to preset constant discharging power, and generating cell discharging efficiency information; performing charging/discharging cycle control on the cell according to the cell charging efficiency information and the cell discharging efficiency information, and obtaining the corresponding charging/discharging cycle control efficiency information; and calculating and generating a cell load state curve by using a cell load algorithm based on the cell charging efficiency information, the cell discharging efficiency information and the charging/discharging cycle control efficiency information, where the cell load algorithm is configured in a preset cell charging/discharging management strategy.

In a second aspect, an embodiment of the present application also provides a load measurement apparatus of a battery balancer, which includes: a first discharging control unit, configured to start a cell in a battery pack corresponding to a connection port through the connection port of the battery balancer, and perform discharging control on the cell until reaching cutoff voltage; a charging control unit, configured to perform charging control on the cell according to preset constant charging power until reaching a preset upper limit of a cell load, and generate cell charging efficiency information; a second discharging control unit, configured to perform discharging control on the cell according to preset constant discharging power until reaching the cutoff voltage and generate cell discharging efficiency information; a charging/discharging cycle control unit, configured to perform charging/discharging cycle control on the cell according to the cell charging efficiency information and the cell discharging efficiency information, and obtain corresponding charging/discharging cycle control efficiency information; and a load state information generation unit, configured to calculate and generate a cell load state curve by using a cell load algorithm based on the cell charging efficiency information, the cell discharging efficiency information and the charging/discharging cycle control efficiency information, where the cell load algorithm is configured in a preset cell charging/discharging management strategy.

In a third aspect, an embodiment of the present application also provides a computer device, which includes a memory and a processor, wherein the memory has computer programs stored thereon, and the processor, when executing the computer programs, implements the method.

In a fourth aspect, an embodiment of the present application also provides a computer readable storage medium, wherein the storage medium has computer programs stored thereon, the computer programs include program instructions, and the program instructions, when executed by a processor, may implement the method.

An embodiment of the present application provides the load measurement method of the battery balancer, the load measurement apparatus of the battery balancer, the computer device and the storage medium. The method includes: correspondingly starting a plurality of cells in the battery pack by using a plurality of connection ports of the battery balancer, and performing the discharging control on the cells until reaching the cutoff voltage; performing the charging control on the cell according to the preset constant charging power until reaching the preset upper limit of the cell load, and generating the cell charging efficiency information; performing the discharging control on the cell according to the preset constant discharging power until reaching the cutoff voltage, and generating the cell discharging efficiency information; performing the charging/discharging cycle control on the cell according to the constant charging power and the constant discharging power, where the charging/discharging cycle control includes multiple charging control and corresponding multiple discharging control, and obtaining charging/discharging cycle control efficiency information; and calculating and generating cell load state information by using the cell load algorithm based on the cell charging efficiency information, the cell discharging efficiency information and the charging/discharging cycle control efficiency information, where the cell load algorithm is configured in the preset cell charging/discharging management strategy, and generating the cell load state curve according to the cell charging/discharging management strategy. According to the embodiments of the present application, due to the accurate estimation on the SOC of the battery by calculating the cycling charging/discharging efficiency through an ampere-hour integration method in an application scene of the battery balancer, higher practicability and effectiveness are achieved; and moreover, the present application has significant advantages and practicability in improving the SOC calculation accuracy, optimizing the battery management and performance evaluation and improving the evaluation capacity of the charging/discharging efficiency, and brings higher efficiency, performance and reliability to the application in the field of batteries.

### Brief Description of the Drawings

To describe the technical solutions of the embodiments of the present application more clearly, the accompanying drawings required for describing the embodiments are introduced briefly below. Apparently, the accompanying drawings in the following description show some embodiments of the present application, and those ordinary skilled in the art may still derive other accompanying drawings from these accompanying drawings without creative efforts.
Figure 1 is a flowchart of a load measurement method of a battery balancer provided by an embodiment of the present application;
Figure 2 is a sub-flowchart of a load measurement method of a battery balancer provided by an embodiment of the present application;
Figure 3 is another sub-flowchart of a load measurement method of a battery balancer provided by an embodiment of the present application;
Figure 4 is a further another sub-flowchart of a load measurement method of a battery balancer provided by an embodiment of the present application;
Figure 5 is a further another sub-flowchart of a load measurement method of a battery balancer provided by an embodiment of the present application;
Figure 6 is another sub-flowchart of a load measurement method of a battery balancer provided by an embodiment of the present application;
Figure 7 is a schematic block diagram of a load measurement apparatus of a battery balancer provided by an embodiment of the present application; and
Figure 8 is a schematic block diagram of a computer device provided by an embodiment of the present application.

### Detailed Description of the Invention

Technical solutions in embodiments of the present application are described clearly and comprehensively in combination with the accompanying drawings in the embodiments of the present application; and apparently, the described embodiments are some embodiments of the present application, not all embodiments. All other embodiments obtained by those ordinary skilled in the art based on the embodiments of the present application without creative efforts shall fall within the protection scope of the present application.

It should be understood that when used in the description and appended claims, terms such as "include" and "comprise" indicate the presence of the described features, integers, steps, operations, elements and/or components, but do not exclude the presence or addition of one or more other features, integers, steps, operations, elements, components and/or groups thereof.

It should also be understood that the terms used in the description of the present application are merely for a purpose of describing a specific embodiment, and are not intended to limit the present application. As used in the description and claims of the present application, unless other circumstances are clearly indicated in the context, the singular forms "a/an", "one" and "the" are intended to include the plural form.

It should also be further understood that the term "and/or" used in the description and claims of the present application refers to any combination of one or more of related items and all possible combinations, and includes these combinations.

An embodiment of the present application provides a load measurement method and apparatus of a battery balancer, a computer device and a storage medium.

An execution body of the load measurement method of the battery balancer may be the load measurement apparatus of the battery balancer provided in the embodiment of the present application or the computer device integrated with the load measurement apparatus of the battery balancer, where the load measurement apparatus of the battery balancer may be implemented in a way of hardware or software, the computer device may be a terminal or a service, and the terminal may be a smart phone, a tablet computer, a palm computer or a notebook computer.

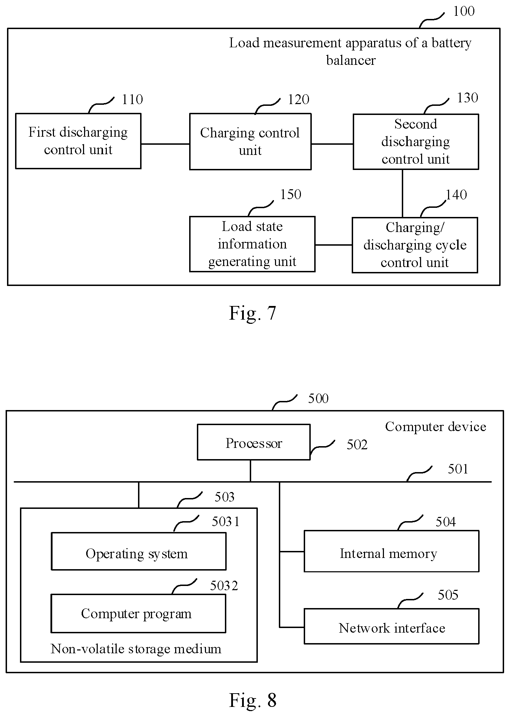

The load measurement method of the battery balancer is applied to a computer device 500 in Figure 8.

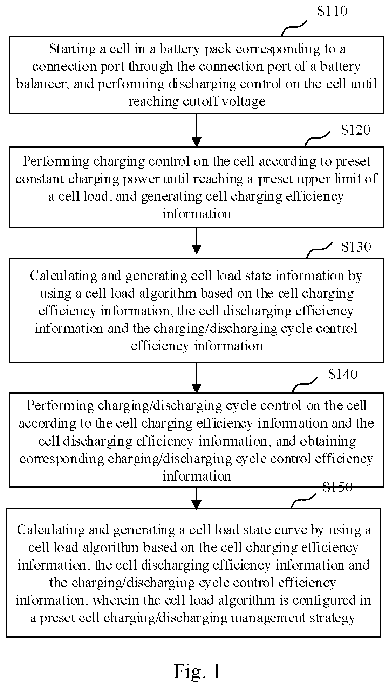

Figure 1 is a flowchart of a load measurement method of a battery balancer provided by an embodiment of the present application. As shown in Figure 1, the method includes steps S110-150.

S110: Starting a cell in a battery pack corresponding to a connection port through the connection port of the battery balancer, and performing discharging control on the cell until reaching cutoff voltage.

Specifically, the cell in the battery pack is started by using the connection port of the battery balancer, and discharging control can be performed on the cell until reaching the cutoff voltage. The battery balancer usually may provide a plurality of connection ports, and each port corresponds to one cell in the battery pack. By means of the connection ports, the battery balancer can monitor and control the state of each cell in real time, and adopt corresponding measures to balance the charging and discharging. In a discharging process, the battery balancer controls a discharging circuit connected to each cell in the battery pack, so that the discharging circuit performs the discharging operation. The cell is discharged until reaching the preset cutoff voltage, so that the cell is prevented from being damaged due to over-discharging. The discharging control can ensure that each cell in the battery pack is kept balanced relatively in the charging/discharging process, which can avoid the imbalance problem caused by great difference in capacity of the cells. At the same time, performing the discharging control on the cell through the battery balancer can also discover and process the abnormal cells in time, thereby improving the overall performance and safety of the battery pack. S120: Performing charging control on the cell according to preset constant charging power until reaching a preset upper limit of a cell load, and generating cell charging efficiency information. Specifically, the charging control can be performed on the cell according to the preset constant charging power until reaching the preset upper limit of the cell load, and the cell charging efficiency information is generated. In a charging process, the battery balancer can control a charging circuit connected to each cell in the battery pack, so that the charging circuit performs the charging according to the preset constant charging power. The charging power can be set according to needs so as to meet specific charging requirements. When a charging state of the cell gradually approaches the preset upper limit of the cell load, the battery balancer may monitor and calculate the charging efficiency of the cell in real time. The charging efficiency refers to a ratio between charging energy absorbed by the cell and inputted charging energy. By calculating the charging efficiency, the charging performance and energy conversion efficiency of the cell can be evaluated. The generated cell charging efficiency information can be used to monitor and evaluate a charging condition of the cell.

S130: Performing discharging control on the cell according to preset constant discharging power until reaching the cutoff voltage, and generating cell discharging efficiency information.

Specifically, the discharging control can be performed on the cell according to the preset constant discharging power until reaching the cutoff voltage, and the cell discharging efficiency information is generated. In a discharging process, the battery balancer can control a discharging circuit connected to each cell in the battery pack, so that the discharging circuit performs the discharging according to the preset constant discharging power. The discharging power can be set according to needs to meet specific discharging requirements. When a discharging state of the cell gradually approaches the cutoff voltage, the battery balancer may monitor and calculate the discharging efficiency of the cell in real time. The discharging efficiency refers to a ratio between discharging energy released by the cell and inputted discharging energy. By calculating the discharging efficiency, the discharging performance and energy conversion efficiency of the cell can be evaluated. The generated cell discharging efficiency information can be used to monitor and evaluate a discharging condition of the cell.

S140: Performing charging/discharging cycle control on the cell according to the cell charging efficiency information and the cell discharging efficiency information, and obtaining corresponding charging/discharging cycle control efficiency information.

Specifically, the charging/discharging cycle control can be performed on the cell according to the constant charging power and the constant discharging power, and the charging/discharging cycle control efficiency information is obtained. The charging/discharging cycle control refers to alternative operation of charging and discharging to specific requirements of charging/discharging cycles. In the charging process, the battery balancer may charge the cell according to the set constant charging power until reaching the preset upper limit of the cell load. However, in the discharging process, the battery balancer may discharge the cell according to the set constant discharging power until reaching the cutoff voltage. In a charging/discharging cycle process, the battery balancer can monitor and calculate the charging and discharging efficiency in real time. The charging efficiency refers to a ratio between the charging energy absorbed or inputted by the cell and outputted discharging energy, which indicates the conversion efficiency of the charging energy. The discharging efficiency refers to a ratio between discharging energy released by the cell and inputted discharging energy, which indicates the conversion efficiency of the discharging energy. By calculating the charging and discharging efficiency, the energy conversion efficiency and performance stability of the cell in the charging/discharging cycle can be evaluated. The generated charging/discharging cycle control efficiency information can be used to monitor and evaluate the performance of the cell in the charging/discharging cycle.

S150: Calculating and generating a cell load state curve by using a cell load algorithm based on the cell charging efficiency information, the cell discharging efficiency information and the charging/discharging cycle control efficiency information, where the cell load algorithm is configured in a preset cell charging/discharging management strategy.

Specifically, by using the cell load algorithm, the load state information of the cell can be calculated and generated based on the charging/discharging efficiency information and charging/discharging cycle control efficiency information of the cell. The load state information of the cell reflects the use situation and health state of the cell. By means of the charging/discharging efficiency information and the charging/discharging cycle control efficiency information, the following calculation and analysis can be performed on the cell: 1, comparison between the charging efficiency and the discharging efficiency: by comparing the charging efficiency and the discharging efficiency, the energy loss of the cell in the charging/discharging process can be evaluated. If the charging efficiency is higher than the discharging efficiency, it may indicate that the capacity of the cell is decreasing or the internal resistance is increasing, so that further examination and maintenance are needed. 2. The charging/discharging cycle control efficiency: the energy conversion efficiency of the cell in the charging/discharging cycle can be evaluated according to the charging/discharging cycle control efficiency information. If the charging/discharging cycle control efficiency is lower than expected, it may indicate that there is problems in the cell, such as energy loss, temperature abnormality, etc. 3. Calculation of the load state: by comprehensively considering the charging/discharging efficiency information and the charging/discharging cycle control efficiency information, the load state information of the cell can be calculated and generated based on the specific cell load algorithm. The load state of the cell can be expressed as a parameter indicating the health condition and load capacity of the cell. By monitoring the load state information of the cell, the abnormality of the cell can be discovered in time, and corresponding measures such as repairing, replacement or maintenance can be adopted to ensure the normal operation and safety of the battery pack.

Specifically, in another embodiment of the present application, a load state curve of the cell can be generated, which can be calculated and analyzed according to various factors such as the cell charging/discharging management strategy, the cell charging/discharging state information and the cell load algorithm. A feasible method is to use a method of fitting relevant parameters to calculate and generate the load state curve of the cell by taking the cell charging/discharging efficiency information, the charging/discharging cycle control efficiency information and the load state information as inputs and combining with an appropriate fitting model. In this way, the health state and load capacity of the cell can be reflected accurately, and the abnormality of the cell can be discovered in time. In specific implementation, the following steps can be adopted: 1, collecting relevant data such as the cell charging/discharging efficiency information, the charging/discharging cycle control efficiency information, the load state information, etc. 2, Selecting the suitable fitting model and algorithm for calculation according to the collected data to obtain the load state curve of the cell. Different methods such as linear regression, nonlinear regression and polynomial fitting can be selected for fitting calculation. 3, Analyzing and evaluating the obtained load state curve of the cell, finding out the abnormality of the cell, and implementing corresponding maintenance or repairing measures. At the same time, the cell charging/discharging management strategy can be formulated according to the obtained load state curve of the cell to optimize the use efficiency and health state of the cell.

In conclusion, the battery balancer is used to perform the charging/discharging control on the cell, and the battery balancer can control current allocation in the charging/discharging process by monitoring parameters such as voltage, current and temperature of each cell so as to realize balance among the cells. The constant charging power and the constant discharging power are set. The battery balancer performs the charging/discharging operations on the cells according to the preset constant charging/discharging power. In the charging process, the battery balancer may monitor the voltage and current and adjust a charging rate according to the preset charging power until reaching the preset upper limit of the cell load. At the same time, by recording the voltage and current data in the charging process, the charging efficiency information of the cell can be calculated. In the discharging process, the battery balancer may also monitor the voltage and current of the cell and adjust a discharging rate according to the preset discharging power until reaching the cutoff voltage. By recording the voltage and current data in the discharging process, the discharging efficiency information of the cell can be calculated. By means of multiple charging/discharging cycle control, the efficiency information of the charging/discharging cycle control can be obtained at different charging/discharging states. These information can be used to evaluate the performance of the battery pack and judge the load state of the cells. The load state information of the cell is calculated and generated by using the cell load algorithm based on the cell charging efficiency information, the cell discharging efficiency information and the charging/discharging cycle control efficiency information. The cell load algorithm may consider the capacity, internal resistance, temperature and other factors of the cell so as to determine the actual load of the cell. The load state curve of the cell is generated according to the preset cell charging/discharging management strategy. The curve can show different states of the cell in the charging/discharging process to provide reference for managing the battery pack. In general, the load measurement method of the battery balancer can perform accurate load measurement and state monitor on the cells in the battery pack by means of precise charging/discharging control and effective data monitoring and analysis, thereby realizing effective management and optimized use of the battery pack. The present application has technical effects that by improving the charging/discharging control and algorithm of the battery balancer, the calculation accuracy of the SOC of the battery pack is improved, the battery management and performance evaluation are optimized, and the evaluation capacity of the charging/discharging efficiency is improved. Firstly, by combining the improved SOC algorithm and the calculation of charging/discharging efficiency, the SOC value of the battery pack can be calculated more accurately. This means that the charging/discharging state of the battery pack can be learned more accurately, which provides more targeted evidence for the battery management. At the same time, the accurate SOC value is also conducive to improving the performance evaluation of the battery pack, so that the health condition and remaining usage time of the battery pack can be learned better. Secondly, the more reasonable battery management can be performed by obtaining the SOC value of the battery pack in real time. The charging/discharging strategy can be formulated according to the accurate SOC value so as to prolong the service life of the battery and improve the performance and safety of the battery pack. The optimized battery management method enables the energy of the battery pack to be used more efficiently and reduces the loss of the battery, thereby improving the efficiency of the whole system. Furthermore, the technology of the present application can also calculate the charging/discharging efficiency of each cell, and provide more comprehensive evaluation on the charging/discharging performance of the battery pack. The charging/discharging efficiency is the energy conversion efficiency of the battery pack in the charging/discharging process, which reflects the working state and health condition of the battery pack. By accurately calculating the charging/discharging efficiency, the problems of the battery pack can be discovered in time, and corresponding measures can be adopted in time for maintenance and repairing, thereby improving the long-term stability and reliability of the battery pack.

In conclusion, the present application has significant advantages and practicability in improving the SOC calculation accuracy, optimizing the battery management and performance evaluation and improving the evaluation capacity of the charging/discharging efficiency. Positive impact may be brought to the service life, performance and safety of the battery pack.

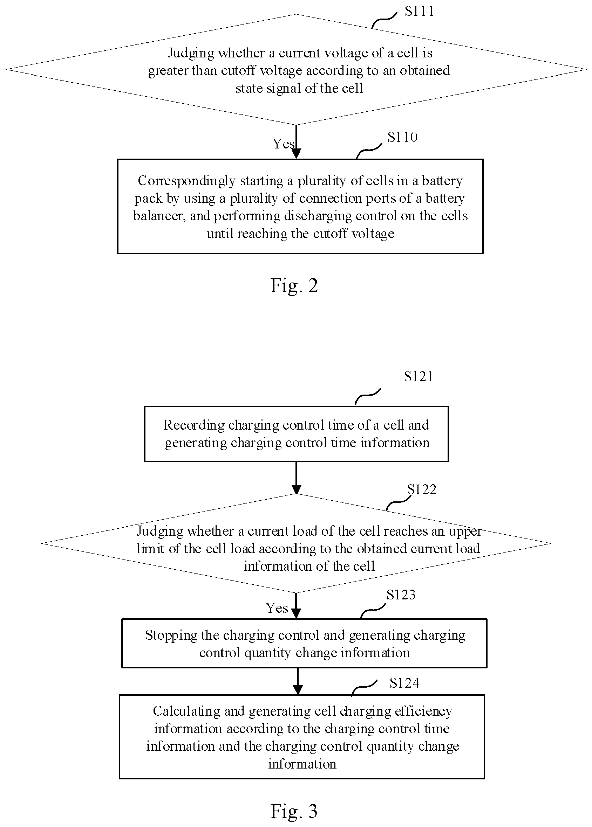

As shown in Figure 2, in a more specific embodiment of the present application, prior to step S110, step S111 shall be executed:
The cutoff voltage of the cell refers to a safe cutoff voltage reached by the battery in the charging or discharging process. The preset cutoff voltage of the cell is determined according to characteristics and design requirements of the battery. For different types of batteries, the cutoff voltage may be different. The following shows the preset cutoff voltage range of some common types of batteries: 1, lithium ion battery (Li-ion): the charging cutoff voltage is usually set at around 4.2 V The discharging cutoff voltage is usually set between 3.0 V and 3.3 V 2. Lead acid storage battery (Lead Acid): the charging cutoff voltage is usually set at 2.35 V to 2.40 V/cell. The discharging cutoff voltage is usually set at 1.75 V to 1.80 V/cell. 3. Nickel-hydrogen battery (NiMH): the charging cutoff voltage is usually set at 1.45 V to 1.55 V/cell. The discharging cutoff voltage is usually set at 1.0 V to 1.1 V/cell.

S111: Judging whether the current voltage of the cell is greater than the cutoff voltage according to an obtained state signal of the cell:
if the current voltage of the cell is greater than the cutoff voltage, executing step S110.

Judging whether the current voltage of the cell is greater than the cutoff voltage. If the current voltage of the cell is greater than the cutoff voltage, executing step S 110, that is, performing balanced discharging on a plurality of cells in the battery pack by using the battery balancer. In the step S110, the cell to be discharged can be selected through the connection port of the battery balancer, and the balanced discharging power can be controlled. The purpose of the balanced discharging is to keep a voltage difference among the cells within a small range, ensure that the state of each cell is more balanced, and discharge the cell to the cutoff voltage to ensure the safety.

As shown in Figure 3, the step S120 further specifically includes steps S121-S124:
S121: Recording the charging control time of the cell and generating charging control time information.

A timer or a time-stamp function can be set in a cell charging control system to record the charging control time and generate the charging control time information of the cell. The timer can be a software-implemented timer or a real-time clock (RTC) on a hardware device. Before the charging control, the timer is started or the current time is recorded as a time-stamp. After the cell completes the charging control process, the timer is stopped or the current time is recorded as an ending time-stamp. The charging control time is calculated according to the starting time and the ending time. A time interval of the charging control can be obtained by using a time difference calculation function or method such as a subtraction operation. The charging control time information is saved in an appropriate data structure such as record files, databases or variables in a memory. The charging control time information can be further processed and analyzed according to the need. For example, the average time, longest time, shortest time and other indexes of each charging control process can be counted for performance evaluation and optimization.

S122: Judging whether a current load of the cell reaches the upper limit of the cell load according to the obtained current load information of the cell.

If the current load of the cell reaches the upper limit of the cell load, executing the following step:
S123: Stopping the charging control and generating charging control quantity change information.

Judging whether the current load of the cell reaches the upper limit of the cell load according to the obtained current load information of the cell, and if the current load is greater than or equal to the upper limit of the cell load, executing step S123; and otherwise, continuing other operations or control. Sending an instruction or signal for stopping the charging control, so that the cell stops receiving the charging. Recording and generating the charging control quantity change information, including relevant information such as the time-stamp for stopping the charging, and current and voltage in the charging control process. Saving the generated charging control quantity change information in an appropriate data structure such as record files, databases or variables in a memory. S124: Calculating and generating cell charging efficiency information according to the charging control time information and the charging control quantity change information.

The calculating and generating charging efficiency information of the cell according to the charging control time information and the charging control quantity change information can be performed in the following steps: calculating a time interval of the charging control, i.e. charging duration by using the charging control time information. The time interval can be usually obtained through a difference between the starting time and the ending time. The total charging power in the charging duration is calculated by using current and voltage data in the charging process in the charging control quantity change information according to the definition of the charging power (power = current × voltage). The actual amount of charge charged into the cell in the charging duration is calculated according to the charged amount recorded in the charging control quantity change information. The actual amount of charge charged into the cell is compared with the total charging power to calculate the charging efficiency of the cell. The charging efficiency can be defined as the amount of charge actually charged into the cell divided by the total charge power and then multiplied by 100 (expressed as a percentage). Charging efficiency = (amount of charge actually charged into the cell/total charging power)* 100, and the calculated charging efficiency information can be saved in an appropriate data structure such as record files, databases or variables in memories for subsequent use or analysis.

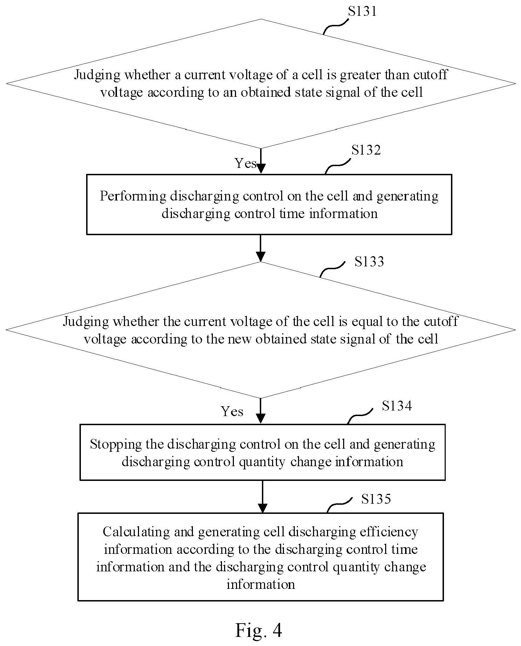

As shown in Figure 4, the step S130 further specifically includes steps S131-S135:
S131: Judging whether the current voltage of the cell is greater than the cutoff voltage according to an obtained state signal of the cell.

If the current voltage of the cell is greater than the cutoff voltage, executing the following step: S132: Performing discharging control on the cell, and generating discharging control time information.

Judging whether the current voltage of the cell is greater than the cutoff voltage according to an obtained state signal of the cell, and executing corresponding discharging control. Operations can be performed in the following steps: obtaining the current voltage and cutoff voltage information of the cell. Comparing the current voltage with the cutoff voltage of the cell. If the current voltage is greater than the cutoff voltage, executing step S132; and otherwise, continuing other operations or control. Performing discharging control on the cell and generating discharging control time information. Sending a discharging control instruction or signal to start the discharging process of the cell. Recording the starting time and the ending time of the discharging control, and generating the discharging control time information. Saving the generated discharging control time information in an appropriate data structure such as record files, databases or variables in memories.

S133: Judging whether the current voltage of the cell is equal to the cutoff voltage according to an obtained state signal of the cell.

If the current voltage of the cell is equal to the cutoff voltage, executing the following step:
S134: Stopping the discharging control of the cell and generating discharging control quantity change information.

Judging whether the current voltage of the cell is equal to the cutoff voltage according to an obtained state signal of the cell, and executing corresponding operations. The operation can be performed in the following step: S133: Obtaining the current voltage and cutoff voltage information of the cell. Comparing the current voltage with the cutoff voltage of the cell. If the current voltage is equal to the cutoff voltage, executing the step S134, and stopping the discharging control of the cell, and generating the discharging control quantity change information. Sending an instruction or signal for stopping the discharging control, so that the cell stops discharging. Recording the discharging stopping time, and generating the discharging control quantity change information. Saving the generated discharging control quantity change information in an appropriate structure such as record files, databases or variables in a memory.

S135: Calculating and generating cell discharging efficiency information according to the discharging control time information and the discharging control quantity change information.

The calculating and generating the discharging efficiency information of the cell according to the discharging control time information and the discharging control quantity change information can be performed in the following steps: calculating a time interval of the discharging control, i.e. discharging duration by using the discharging control time information. The time interval can be usually obtained through a difference between the starting time and the ending time. The total discharging power in the discharging duration is calculated by using current and voltage data in the discharging process in the discharging control quantity change information according to the definition of the discharging power (power = current × voltage). An amount of charge actually released by the cell in the discharging duration is calculated according to the discharged amount recorded in the discharging control quantity change information. The amount of charge actually released by the cell is compared with the total discharging power to calculate the discharging efficiency of the cell. The discharging efficiency can be defined as the amount of charge actually released by the cell divided by the total discharging power and then multiplied by 100 (expressed as a percentage). Discharging efficiency = (the amount of charge actually released by the cell/total discharging power)*100. The calculated discharging efficiency information can be saved in an appropriate data structure such as record files, databases or variables in memories for subsequent use or analysis.

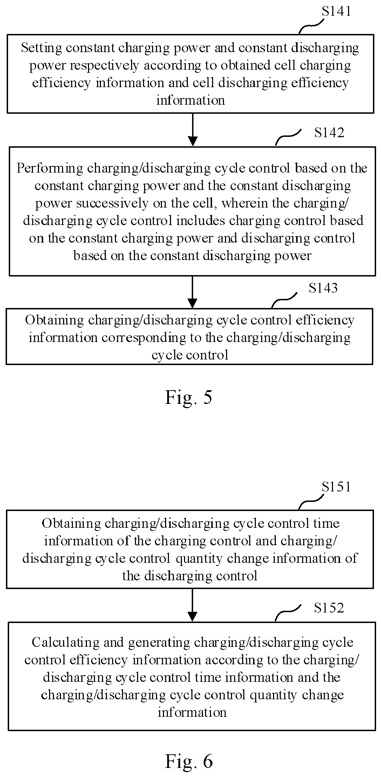

As shown in Figure 5, the step S140 further specifically includes steps S141-S143:
S141: Setting constant charging power and constant discharging power respectively according to the obtained cell charging efficiency information and cell discharging efficiency information.

The constant charging power and discharging power can be set according to the obtained cell charging efficiency information and discharging efficiency information. The following shows the steps of setting the constant charging power and the constant discharging power respectively: setting the constant charging power: determining a target charging efficiency value (e.g. 90%) according to the charging efficiency information of the cell. Calculating the charging power, i.e. the target charging power when the charging efficiency is the target charging efficiency. Taking the target charging power as the constant charging power, that is, maintaining the constant charging power in the charging process. Setting the constant discharging power: determining a target discharging efficiency value (e.g. 95%) according to the discharging efficiency information of the cell. Calculating the discharging power, i.e. the target discharging power when the discharging efficiency is the target discharging efficiency. Taking the target discharging power as the constant discharging power, that is, maintaining the constant discharging power in the discharging process.

S142: Performing charging/discharging cycle control based on the constant charging power and the constant discharging power successively on the cell, wherein the charging/discharging cycle control includes the charging control based on the constant charging power and the discharging control based on the constant discharging power.

The performing the charging control based on the constant charging power and the discharging control based on the constant discharging power successively on the cell can be performed in the following steps: 1, charging control based on the constant charging power: taking the constant charging power as the target power value when in charging. Calculating the current charging power by monitoring the charging current and voltage information of the cell, and comparing the current charging power with the target power. Adjusting the charging current or the charging voltage according to the power difference, the charging efficiency and other factors to enable the actual charging power to gradually approach the target power. Continuously monitoring the charging state (such as current, voltage, temperature, etc.) of the cell during the charging, and adjusting the charging parameters according to needs to ensure the safety and reliability of the charging process. 2. Discharging control based on the constant discharging power: taking the constant discharging power as a target power value when in discharging. Calculating the current discharging power by monitoring the discharging current and voltage information of the cell, and comparing the discharging power with the target power. Adjusting the discharging current or the discharging voltage according to the power difference, the discharging efficiency and other factors to enable the actual discharging power to gradually approach the target power. Continuously monitoring the discharging state (such as current, voltage, temperature, etc.) of the cell during the discharging, and adjusting the discharging parameters according to needs to ensure the safety and reliability of the discharging process.

S143: Obtaining charging/discharging cycle control efficiency information corresponding to the charging/discharging cycle control.

The method for generating the charging/discharging cycle control time information and the charging/discharging cycle control quantity change information depends on specific applications and requirements. 1. Charging/discharging cycle control time information: determining the duration of each charging and discharging cycle according to actual needs and characteristics of the cell. For example, the time of each cycle can be set as 30 minutes. Considering extra time (such as balanced charging, break time, etc.) that may be needed in the charging and discharging process, the time of each cycle can be adjusted appropriately according to experience or engineering requirements. When the charging/discharging cycle control time information is generated, the starting time and ending time of each charging and discharging cycle can be recorded for subsequent analysis and monitoring. 2. Charging/discharging cycle control quantity change information: for the charging process, the charging control quantity change information may include: charging current: setting a constant charging current value or dynamically adjusting the charging current according to the charging efficiency and the state of the cell. Charging voltage: setting a constant charging voltage value or dynamically adjusting the charging voltage according to the charging efficiency and the voltage characteristics of the cell. Charging time: determining a changing pattern of the charging time according to the set charging cycle time and specific charging strategies. For the discharging process, the discharging control quantity change information may include: discharging current: setting a constant discharging current value or dynamically adjusting the discharging current according to the discharging efficiency and the state of the cell. Discharging voltage: setting a constant discharging voltage value or dynamically adjusting the discharging voltage according to the discharging efficiency and the voltage characteristics of the cell. Discharging time: determining a changing pattern of the discharging time according to the set discharging cycle time and specific discharging strategies.

As shown in Figure 6, the step S150 further specifically includes steps S151-S152:
S151: Obtaining charging/discharging cycle control time information of the charging control and the charging/discharging cycle control quantity change information of the discharging control.

To obtain the charging/discharging cycle control time information and the charging/discharging cycle control quantity change information needs to be designed and realized according to specific control strategies and algorithms of a battery management system or an electronic device. The following shows some universal methods for obtaining these information: the charging/discharging cycle control time information: setting a timer or a counter in a code or program for recording the starting and ending time of the charging/discharging cycle. The timer is started at a starting point at a starting point of the charging and discharging process, and the timer is stopped at an ending point. The duration of the charging/discharging cycle can be obtained according to a numerical value of the timer. The charging/discharging cycle control quantity change information: defining charging/discharging control parameters in the code or program, such as charging current, discharging current, charging voltage, discharging voltage, etc. In the charging and discharging process, whether the control parameters need to be adjusted is determined by reading data of a sensor or monitoring the state of the battery according to the set control strategy and algorithm in the charging and discharging process. If the adjustment is needed, the set value of the charging/discharging current or voltage can be changed in a programming way so as to change the control quantity.

S152: Calculating and generating charging/discharging cycle control efficiency information according to the charging/discharging cycle control time information and the charging/discharging cycle control quantity change information.

To calculate and generate the charging/discharging cycle control efficiency information, the following steps can be performed based on the charging/discharging cycle control time information and the charging/discharging cycle control quantity change information: calculating the charging efficiency: charging efficiency can be calculated through the following formula: charging efficiency = (actual stored energy/inputted energy)×100%. The actual stored energy is the energy actually stored in the battery in the charging process, which can be obtained by measuring the battery power at the end of the charging. The inputted energy is total energy for charging, which can be calculated by measuring the inputted electric energy or the charging current and voltage. 2. Calculating the discharging efficiency: the discharging efficiency can be calculated through the following formula: discharging efficiency = (outputted energy/actual stored energy)×100%. The outputted energy is the actual energy extracted from the battery, which can be obtained by measuring the battery power at the end of the discharging.

In some embodiments of the present application, the step S150 further includes steps S153-S154: S153: Obtaining time, voltage and current in the cell charging efficiency information, the cell discharging efficiency information and the charging/discharging cycle control efficiency information as target parameters.

S154: Inputting the target parameters into the cell load algorithm to generate a cell load state curve.

The time, voltage and current related parameters in the cell charging efficiency information, the cell discharging efficiency information and the charging/discharging cycle control efficiency information need to be obtained by dedicated devices such as the battery management system or a test instrument. Generally, these devices can collect the voltage and current data of the cell by connecting positive and negative electrodes of the cell, and calculate the charging/discharging efficiency, the cycle control efficiency and other parameters of the cell through an internal algorithm. Time-related parameters: the charging/discharging time of the cell is usually recorded by a timer, the starting time and the ending time of the charging and discharging can be recorded, and the charging/discharging time difference can be calculated. Voltage-related parameters: devices such as a voltmeter or a multi-channel data collector can be used to measure voltage of the cell, record the voltage of the cell at the beginning and ending of the charging/discharging, and calculate the parameters such as an average voltage value during the charging and discharging. Current-related parameters: devices such as an ammeter or a multi-channel data collector can be used to measure current of the cell, record the current of the cell at the beginning and ending of the charging/discharging, and calculate the parameters such as an average current value during the charging and discharging.

Figure 7 is a schematic block diagram of a load measurement apparatus of a battery balancer provided by an embodiment of the present application. As shown in Figure 7, corresponding to the above load measurement method of the battery balancer, the present application also provides a load measurement apparatus 100 of a battery balancer. The load measurement apparatus of the battery balancer includes units for executing the above load measurement method of the battery balancer, and the apparatus may be configured in terminals such as a desktop computer, a tablet computer, a portable computer, and the like. Specifically, referring to Figure 7, the load measurement apparatus 100 of the battery balancer includes a first discharging control unit 110, a charging control unit 120, a second discharging control unit 130, a charging/discharging cycle control unit 140 and a load state information generating unit 150.

The first discharging control unit 110 is configured to start a cell in a battery pack corresponding to a connection port through the connection port of the battery balancer and perform discharging control on the cell until reaching cutoff voltage.

The charging control unit 120 is configured to perform charging control on the cell until reaching a preset upper limit of a cell load according to preset constant charging power and generate cell charging efficiency information.

The second discharging control unit 130 is configured to perform discharging control on the cell until reaching cutoff voltage according to preset constant discharging power and generate cell discharging efficiency information.

The charging/discharging cycle control unit 140 is configured to perform charging/discharging cycle control on the cell according to the cell charging efficiency information and the cell discharging efficiency information and obtain the corresponding charging/discharging cycle control efficiency information.

The load state information generating unit 150 is configured to calculate and generate a cell load state curve by using a cell load algorithm based on the cell charging efficiency information, the cell discharging efficiency information and the charging/discharging cycle control efficiency information, and the cell load algorithm is configured in a preset cell charging/discharging management strategy. It should be stated that those skilled in the art may clearly learn about that the specific implementation process of the above load measurement apparatus of the battery balancer and various units may refer to the corresponding descriptions in the method embodiments, which is not repeated here for the convenience and brevity of description.

The above load measurement apparatus of the battery balancer may be implemented in a form of computer programs, and the computer programs may be run on the computer device as shown in Figure 8.

Referring to Figure 8, Figure 8 is a schematic block diagram of a computer device provided by an embodiment of the present application. The computer device 500 may be a terminal or a server, wherein the terminal may be a smart phone, a tablet computer, a notebook computer, a desktop computer, a personal digital aid, a wearable device and other electronic devices with a communication function. The server may be an independent server or a server cluster composed of a plurality of servers.

Referring to Figure 8, the computer device 500 includes a processor 502, a memory and a network interface 505 which are connected through a system bus 501, wherein the memory can include a non-volatile storage medium 503 and an internal memory 504.

The non-volatile storage medium 503 may store an operating system 5031 and computer programs 5032. The computer programs 5032 include program instructions, and the program instructions, when executed, may make the processor 502 execute a load measurement method of a battery balancer.

The processor 502 is used to provide computation and control ability to support the running of the whole computer device 500.

The internal memory 504 provides an environment for the running of the computer programs 5032 in the non-volatile storage medium 503, and the computer programs 5032, when executed by the processor 502, may make the processor 502 execute a load measurement method of a battery balancer.

The network interface 505 is configured to perform network communication with other devices. A person skilled in the art may understand that, the structure shown in Figure 8 is merely a block diagram of a partial structure related to a solution in the present application, and does not constitute a limitation to the computer device 500 to which the solution in the present application is applied. Specifically, the computer device 500 may include more components or fewer components than those shown in the figure, or some components may be combined, or a different component deployment may be used.

It should be understood that in embodiments of the present application, the processor 502 may be a central processing unit (CPU), and the processor 502 may also be a general-purpose processor, a digital signal processor (DSP), an application specific integrated circuit (ASIC), a field - programmable gate array (FPGA) or other programmable logic devices, discrete gate or transistor logic devices, discrete hardware components, etc. The general-purpose processor may be a micro processor or the processor may also be any conventional processor.

Those ordinary skilled in the art may understand that all or some of the processes of the methods in the embodiments may be implemented by a computer program instructing relevant hardware. The computer programs include program instructions, and the computer programs may be stored in a storage medium, and the storage medium is a computer readable storage medium. The program instructions are executed by at least one processor in the computer system so as to implement process steps in the embodiments of the method.

Therefore, the present application further provides a storage medium. The storage medium may be a computer readable storage medium. The storage medium has computer programs stored thereon, and the computer programs include program instructions.

The storage medium may be various computer readable media capable of storing the program codes, such as a USB flash drive, a portable hard disk, a Read-Only Memory (ROM), a magnetic disk or a compact disk, etc.

Those ordinary skilled in the art can realize that units and algorithm steps of various examples described in the embodiments disclosed here can be implemented by electronic hardware, computer hardware or a combination of the two. In order to clearly illustrate the interchangeability of the hardware and the software, the composition and steps of each example are already described generally in accordance with functions in the above description. Whether these functions are executed with hardware or software depend on the specific application and designed constraint conditions of the technical solution. Professional technicians can use different methods to implement the described functions for each specific application, but such implementation should not be considered beyond the scope of the present application.

In the embodiments provided in the present application, it should be understood that the disclosed apparatuses and methods may be implemented in other ways. For example, the apparatus embodiments described above are merely illustrative. For example, the division of each unit is only a logic functional division, and there may be other divisions in actual implementation. For example, a plurality of units or components may be combined or integrated into another system, or some features may be ignored or not executed.

The steps in the method in the embodiments of the present application can be adjusted in sequence, merged and deleted according to actual needs. The units in the device in the embodiments of the present application may be combined, divided and deleted according to actual needs. Furthermore, all functional units in various embodiments of the present application may be integrated into one processing unit, may also be physically separated, or two or more of the functional units may be integrated into one unit.

If the integrated unit is implemented in the form of a software functional unit and sold or used as an independent product, it can be stored in a storage medium. Based on this understanding, the technical solutions of the present application or the part contributing to the prior art or all or part of the technical solutions can be essentially embodied in a form of software products. The computer software product can be stored in a computer readable storage medium including a plurality of instructions for making a computer device (which may be a personal computer, a terminal, or a network device, etc.) execute all or some steps of the methods described in each embodiment of the present application.

The above descriptions are only specific embodiments of the present application, but the protection scope of the present application is not limited thereto. Various equivalent modifications or replacements made by the technical skilled familiar with the prior art within the technical scope disclosed by the present application shall be covered by the protection scope of the present application. Therefore, the protection scope of the present application should be subjected to the protection scope defined by the claims.

## Claims

1. A load measurement method of a battery balancer, applied to the battery balancer, a plurality of connection ports of the battery balancer being correspondingly connected with a plurality of cells of a battery pack to perform charging/discharging control on the battery pack, **characterized by** comprising:
starting the cell in the battery pack corresponding to the connection port through the connection port of the battery balancer, and performing discharging control on the cell until reaching cutoff voltage;
performing charging control on the cell according to preset constant charging power until reaching a preset upper limit of a cell load, and generating cell charging efficiency information;
performing discharging control on the cell according to preset constant discharging power until reaching the cutoff voltage, and generating cell discharging efficiency information;
performing charging/discharging cycle control on the cell according to the cell charging efficiency information and the cell discharging efficiency information, and obtaining corresponding charging/discharging cycle control efficiency information; and
calculating and generating a cell load state curve by using a cell load algorithm based on the cell charging efficiency information, the cell discharging efficiency information and the charging/discharging cycle control efficiency information, the cell load algorithm being configured in a preset cell charging/discharging management strategy.

2. The load measurement method of the battery balancer according to claim 1, **characterized in that** prior to starting the cell in the battery pack corresponding to the connection port through the connection port of the battery balancer, the method further comprises:
judging whether current voltage of the cell is greater than the preset cutoff voltage according to an obtained state signal of the cell; and
if the current voltage is greater than the cutoff voltage, executing the step of starting the cell in the battery pack corresponding to the connection port through the connection port of the battery balancer.

3. The load measurement method of the battery balancer according to claim 2, **characterized in that** the performing charging control on the cell according to preset constant charging power until reaching a preset upper limit of a cell load and generating cell charging efficiency information comprises:
recording charging control time of the cell and generating charging control time information;
judging whether a current load of the cell reaches the upper limit of the cell load according to the obtained current load information of the cell;
if the current load of the cell reaches the upper limit of the cell load, stopping the charging control,
and generating charging control quantity change information; and
calculating and generating the cell charging efficiency information according to the charging control time information and the charging control quantity change information.

4. The load measurement method of the battery balancer according to claim 3, **characterized in that** the performing discharging control on the cell according to preset constant discharging power until reaching the cutoff voltage and generating cell discharging efficiency information comprises:
judging whether the current voltage of the cell is greater than the cutoff voltage according to the obtained state signal of the cell; and
if the current voltage is greater than the cutoff voltage, performing discharging control on the cell and generating discharging control time information;
judging whether the current voltage of the cell is equal to the cutoff voltage according to a new obtained state signal of the cell;
if the current voltage is equal to the cutoff voltage, stopping the discharging control on the cell and generating discharging control quantity change information; and
calculating and generating the cell discharging efficiency information according to the discharging control time information and the discharging control quantity change information.

5. The load measurement method of the battery balancer according to claim 4, **characterized in that** the performing charging/discharging cycle control on the cell according to the cell charging efficiency information and the cell discharging efficiency information, and obtaining corresponding charging/discharging cycle control efficiency information comprises:
setting constant charging power and constant discharging power respectively according to the obtained cell charging efficiency information and cell discharging efficiency information;
performing charging/discharging cycle control based on the constant charging power and the constant discharging power successively on the cell, the charging/discharging cycle control comprising charging control based on the constant charging power and discharging control based on the constant discharging power; and
obtaining charging/discharging cycle control efficiency information corresponding to the charging/discharging cycle control.

6. The load measurement method of the battery balancer according to claim 5, **characterized in that** the obtaining charging/discharging cycle control efficiency information corresponding to the charging/discharging cycle control comprises:
obtaining charging/discharging cycle control time information of the charging control and
charging/discharging cycle control quantity change information of the discharging control; and
calculating and generating the charging/discharging cycle control efficiency information according to the charging/discharging cycle control time information and the charging/discharging cycle control quantity change information.

7. The load measurement method of the battery balancer according to claim 6, **characterized in that** the calculating and generating a cell load state curve by using a cell load algorithm based on the cell charging efficiency information, the cell discharging efficiency information and the charging/discharging cycle control efficiency information comprises:
obtaining time, voltage and current in the cell charging efficiency information, the cell discharging efficiency information and the charging/discharging cycle control efficiency information as target parameters; and
inputting the target parameters to the cell load algorithm to generate the cell load state curve.

8. A load measurement apparatus of a battery balancer, **characterized by** comprising:
a first discharging control unit, configured to correspondingly start a plurality of cells in a battery pack by using a plurality of connection ports of the battery balancer, and perform discharging control on the cells until reaching cutoff voltage;
a charging control unit, configured to perform charging control on the cell according to preset constant charging power until reaching a preset upper limit of a cell load and generate cell charging efficiency information;
a second discharging control unit, configured to perform discharging control on the cell according to preset constant discharging power until reaching the cutoff voltage and generate cell discharging efficiency information;
a charging/discharging cycle control unit, configured to perform charging/discharging cycle control on the cell according to the constant charging power and the constant discharging power, the charging/discharging cycle control comprising multiple charging control and corresponding multiple discharging control, and obtain charging/discharging cycle control efficiency information;
a load state information generating unit, configured to calculate and generate cell load state information by using a cell load algorithm based on the cell charging efficiency information, the cell discharging efficiency information and the charging/discharging cycle control efficiency information; and
a load state curve generating unit, configured to generate a cell load state curve according to a cell charging/discharging management strategy.

9. A computer device, **characterized by** comprising a memory and a processor, wherein the memory has computer programs stored thereon, and the processor, when executing the computer programs, implements the method according to any one of claims 1-7.

10. A computer readable storage medium, **characterized by** storing computer programs, wherein the computer programs comprise program instructions, the program instructions, when executed by a processor, may implement the method according to any one of claims 1-7.
